# EUROPEAN PATENT APPLICATION

(11) **EP 2 309 558 A2**
(43) Date of publication of application: **13.04.2011**
(21) Application number: 10186965.9
(22) Date of filing: 08.10.2010
(51) Int. Cl.: H01L 33/50, H01L 33/64

(54) **Light emitting diode and manufacturing method thereof**

(30) Priority: 12.10.2009 US 250580 P
(71) Applicant: Intematix Technology Center Corp., Taoyuan County 326 (TW)
(72) Inventor: Cheng, Tzu-Chi, Taoyuan County Taoyuan City (TW)
(74) Representative: Viering, Jentschura & Partner

(57) **Abstract**

A light emitting diode manufacturing method introduces a transparent enclosure to improve the uniformity of coating phosphor, so as to achieve the purposes of enhancing the uniform color temperature and the light emitting efficiency. The manufacturing method is used extensively for packaging various types of light emitting diode chips and mass production.

## Description

### BACKGROUND OF THE INVENTION

### Field of the Invention

The present invention relates to a light emitting diode and a manufacturing method thereof, and more particularly to a light emitting diode manufacturing method and a light emitting diode manufactured by the method capable of enhancing the uniformity of color temperature and the light emitting efficiency of a white light emitting diode device.

### Description of the Related Art

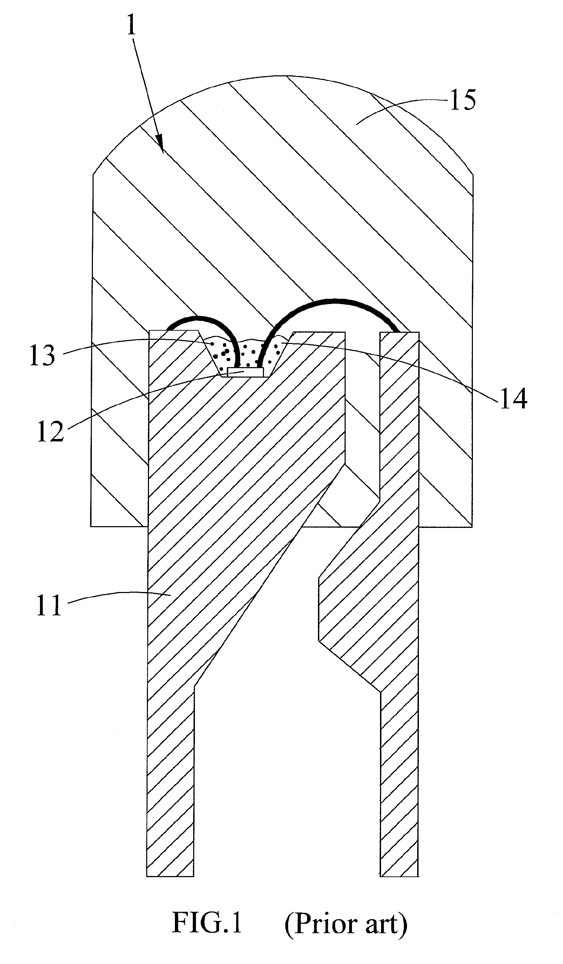

FIG. 1 illustrates a schematic view of a white light emitting diode disclosed in U.S. Pat. No. 5,998,925. The white light emitting diode 1 comprises a lead frame 11, a GaN-based light emitting diode chip 12 for emitting a light with a first wavelength, and a phosphor 13. The phosphor 13 absorbs a part of radiation energy produced by the GaN-based light emitting diode chip 12 and emits a light with a second wavelength, so as to obtain a white light with a third wavelength mixed from first and second wavelengths. In FIG. 1, the phosphor 13 and the first resin are mixed to form a mixed resin 14 containing the phosphor 13. Then the mixed resin 14 is filled into a cup of the lead frame 11 that carries the GaN-based light emitting diode chip completely cover the GaN-based light emitting diode chip 12. A second resin 15 is then used for sealing the lead frame 11, the GaN-based light emitting diode chip 12 and the mixed resin 14 to complete the manufacture of the white light emitting diode. Since the thickness of the mixed resin 14 filled in the cup of the lead frame can not controlled intentionally, the phosphor may be distributed uniformly. Thus the brightness of the emitted lights in different directions and the color temperature are not uniform.

US 5,959,316 disclsoes another a white light emitting diode device, which is illustrated in FIG. 2. A light emitting diode chip 22 is placed on a lead frame 21, and then a first transparent packaging resin 23 is used to seal and cover the top of the light emitting diode chip 22. A mixed resin 24 is provided by a phosphor mixed with a second transparent packaging resin, and then the mixed resin 24 is used for sealing and covering the first transparent packaging resin 23. A third transparent packaging resin 25 is used for sealing and covering the mixed resin 24. Since the first transparent packaging resin 23 is baked and dried to constitute a circular top, and therefore the mixed resin 24 containing the phosphor can be coated onto the circular top with a specific thickness to overcome the drawbacks of having the non-uniform angular distribution of color temperature of the light emitting device. The manufacturing method dislcsoed in the prior art involves producing the first transparent packaging resin 23, mixed resin 24 and third transparent packaging resin 25, and then performing an encapsulation process. The encapsulation process requires a step of baking and drying for each resin by a high temperature. Such manufacturing processes will contaminate surfaces of the resins and cause an insufficient adhesive force between resins. Futher it is difficult to improve the yield rate of the manufacturing process or simplify the manufacturing process.

FIG. 3 illustrates another light emitting element as disclosed in U.S. Pat. No. 6,576,488. This patent discloses a flip chip packaging method and provides a selective electrophoresis deposition technology for a phosphor to improve the uniformity of the phosphor coated onto the light emitting diode chip, so as to overcome the drawback of having a non-uniform angular distribution of color temperature. Firstly, the light emitting diode chip 32 is mounted onto a substrate 31 by a flip chip manufacturing method. An electrophoresis apparatus 34 carrying a phosphor 33 is applied with a specific voltage such that the phosphor 33 will be deposited on an exposed surface of the light emitting diode chip 32. Since the phosphor 33 is distributed to have a uniform thickness, the uniformity of color temperature angular distribution can be improved effectively. Although the manufacturing process can improve the uniformity of color temperature angular distribution, the complexity of the chip manufacturing process and the manufacturing cost are likely to increase since the process requires various photomasks for the light emitting diode chip 32 and the substrate 31 to prevent phosphor from being deposited on a metal conductive area if the selective electrophoresis deposition process is adopted.

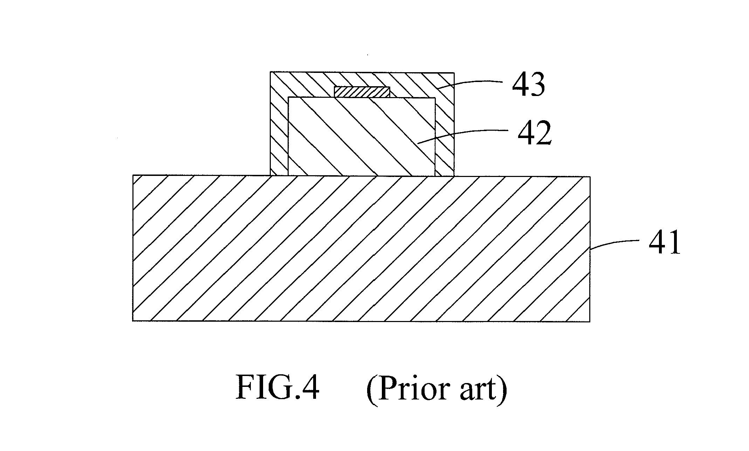

FIG. 4 illustrates another method of producing a white light emitting device uniformly coated with a phosphor as disclosed in U.S. Patent Publication No. 20050244993. A light emitting diode chip 42 having a vertical electrode structure is provided and mounted onto a substrate 41, and then a phosphor mixed with another suspension is provided. As the mixed solution is sprayed at the periphery of the light emitting diode chip 42, a phosphor coating layer 43 with a uniform thickness can be formed to improve the uniformity of the color temperature angular distribution effectively.

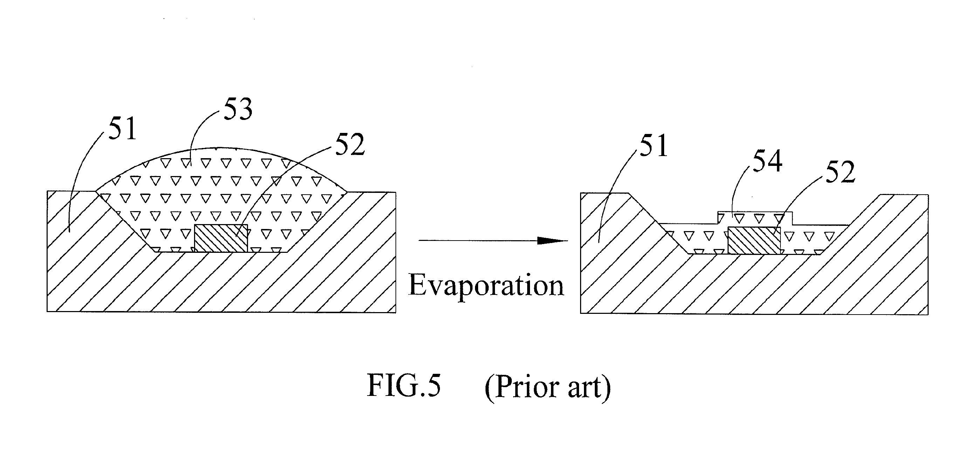

FIG. 5 illustrates another method of producing a white light emitting device uniformly coated with a phosphor as disclosed in U.S. Pat. No. 7,217,583. A light emitting diode chip 52 is provided and mounted onto a substrate 51, and then a phosphor mixed with a mixed solution 53 of a suspension is provided and and formed on the light emitting diode chip 52. Then, the mixed solution 53 is confined and the evaporation process of the mixed solution 53 is controlled to form a phosphor coating layer 54 with a uniform thickness at the periphery of the light emitting diode chip 52 to improve the uniformity of the color temperature angular distribution effectively.

Thus, there is a need to develop a new method to uniformly coat a phosphor at the periphery of a light emitting diode chip and a light emitting diode manufactured by this method to simplify the manufacture process and the cost.

### SUMMARY OF THE INVENTION

In view of the shortcomings of the prior art, a light emitting diode and a manufacturing method thereof are provided to overcome the problem of having a non-uniform color temperature angular distribution caused by a non-uniform phosphor.

The light emitting diode manufacturing method, particularly a method of packaging a light emitting diode chip by a transparent enclosure, may overcome the problem of having a non-uniform color temperature angular distribution caused by a non-uniformly coated phosphor and improve the light emitting efficiency of light emitting diode device.

The light emitting diode manufacturing method, particularly a method of packaging a light emitting diode chip by a transparent enclosure may further achieve the effects of simplifying the manufacturing process and reducing the cost.

To achieve these and other advantages and in accordance with the purpose of the present invention, as embodied and broadly described herein, the embodiment of this disclosure discloses a light emitting diode manufacturing method comprising the steps of: providing a lead frame; mounting at least one light emitting diode chip onto the lead frame; electrically coupling the light emitting diode chip and the lead frame; forming a transparent enclosure to enclose the light emitting diode chip; and coating a packaging resin containing a phosphor in an area having the light emitting diode chip and enclosed by the enclosure.

The embodiment of this disclosure discloses a white light emitting diode, comprising a lead frame, a light emitting diode chip, a transparent enclosure and a mixed resin having a phosphor. The light emitting diode chip is mounted onto the lead frame. The transparent enclosure is provided for enclosing the light emitting diode chip. The mixed resin containing a phosphor is formed in an area enclosed by the enclosure.

In summation of the description above, the light emitting diode and its manufacturing method in accordance with the present invention have one or more of the following technical effects.The light emitting diode and the manufacturing method thereof enclose the light emitting diode chip by the transparent enclosure to improve the uniformity of coating the phosphor and the light emitting efficiency of the light emitting diode device. The light emitting diode and the manufacturing method thereof enclose the light emitting diode chip by the transparent enclosure to achieve the effects of simplifying the process of uniformly coating the phosphor and reducing the manufacturing cost.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.
FIG. 1 is a schematic view of a first conventional white light emitting diode;

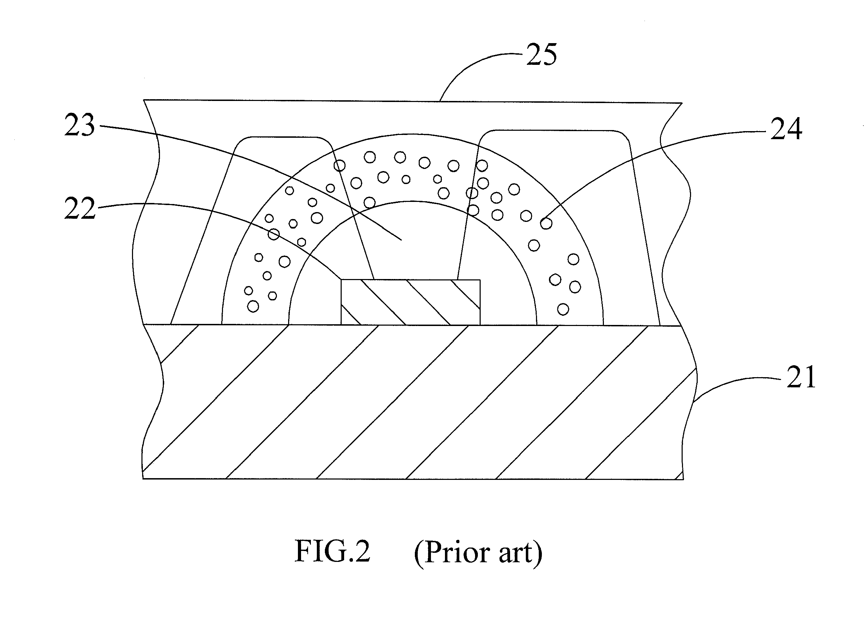

FIG. 2 is a schematic view of a second conventional white light emitting diode;

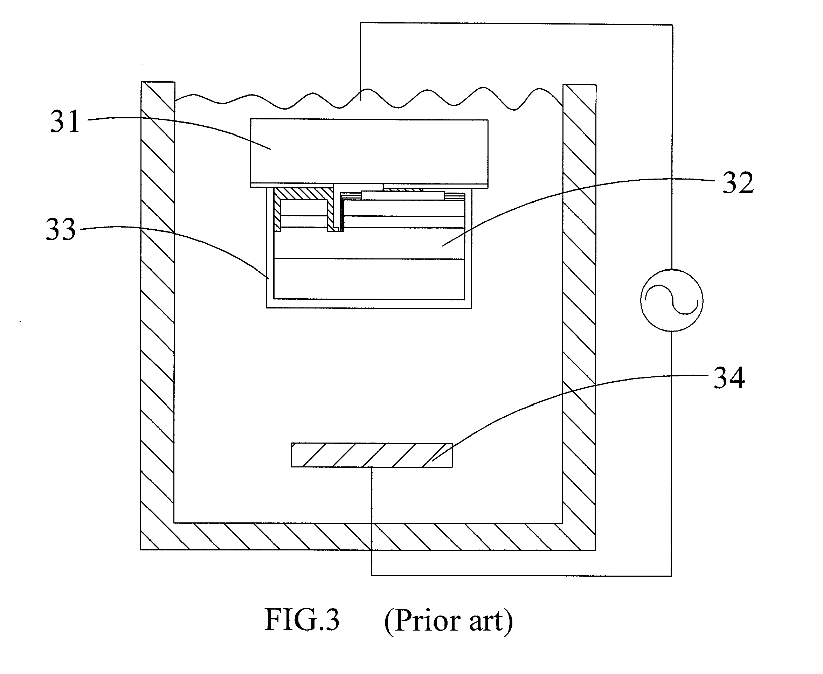

FIG. 3 is a schematic view of a third conventional white light emitting diode;
FIG. 4 is a schematic view of a fourth conventional white light emitting diode;
FIG. 5 is a schematic view of a fifth conventional white light emitting diode;
FIG. 6 is a schematic view of a light emitting diode in accordance with the present invention;
FIGS. 7A~7C are schematic views showing the manufacturing procedure of a light emitting diode in accordance with the present invention; and
FIG. 8 is a schematic view of another light emitting diode in accordance with the present invention.

### DETAILED DESCRIPTION OF THE PREFERRED EMBODIMENTS

Reference will now be made in detail to the preferred embodiments, examples of which are illustrated in the accompanying drawings.

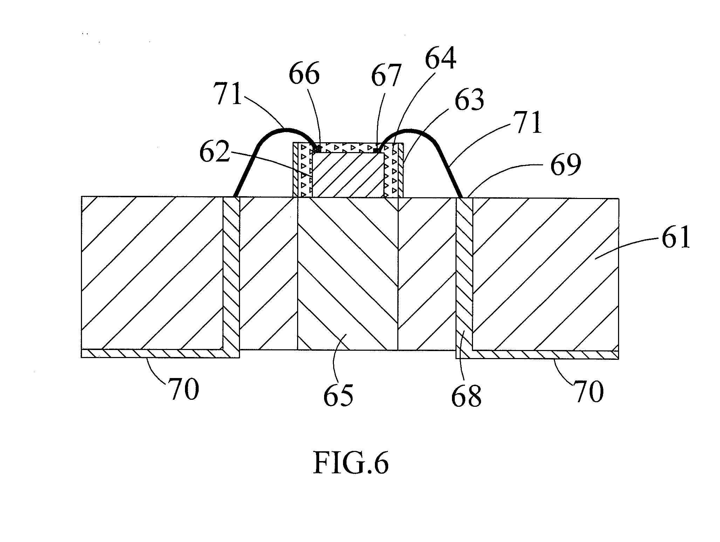

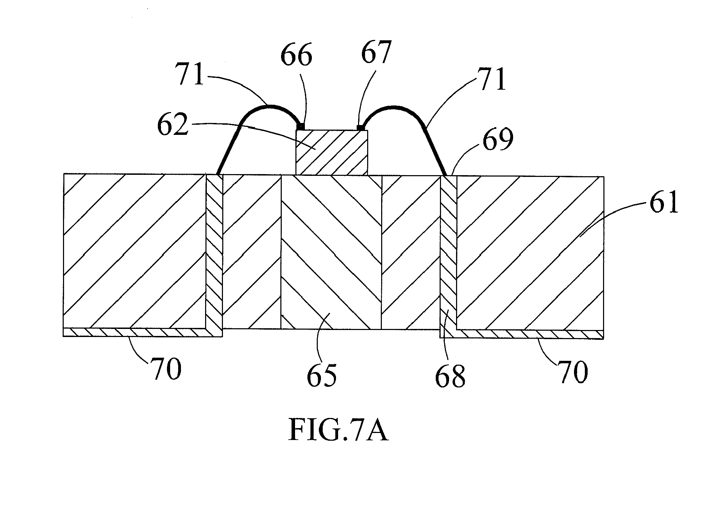

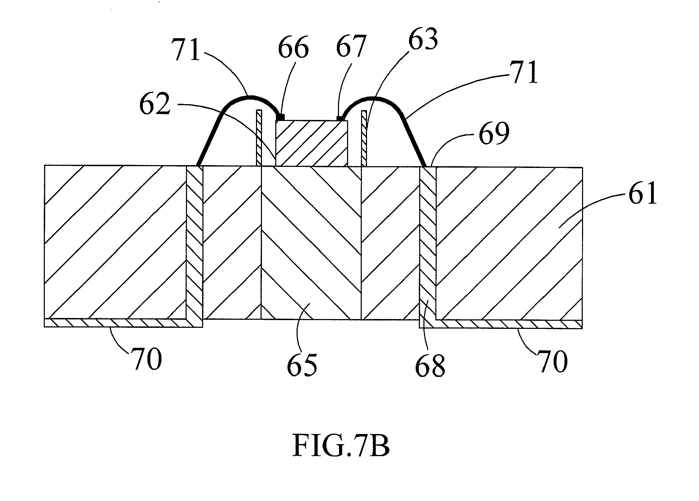

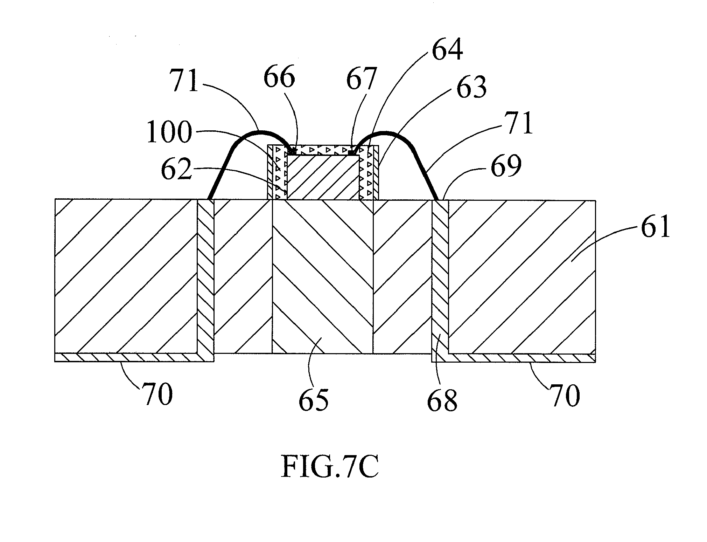

With reference to FIG. 6 for a schematic view of a light emitting diode in accordance with the present invention, the manufacturing process of the light emitting diode comprises the steps of: providing a lead frame 61, mounting a light emitting diode chip 62 onto the lead frame 61, forming an enclosure 63 for enclosing the light emitting diode chip 62 and providing at least one mixed resin 64 containing a phosphor in the enclosure 63 to cover onto the light emitting diode chip 62. The enclosure 63 can be formed by a spray coating method, a screen coating method, a sol-gel method, a dispensing method, a die-casting method or the like. The lead frame 61 can be made of a composite material selected from the group of a ceramic based material, an aluminum oxide based (AlO-based) material, copper, aluminum, molybdenum, tungsten, and an aluminum nitride based (AlN-based) material. The lead frame 61 further includes a bonding area 65, an electrically connected circuit 68, a pad 69, and an electrode terminal 70. In addition, the bonding area 65 can be made of a conductor, a non-conductor, or their mixture. The light emitting diode chip 62 and the enclosure 63 have a relative distance with each other. A preferred distance can be adjusted according to the size of the light emitting diode chip 62 and the lead frame 61. The enclosure 63 is made of a transparent material, and the predermined thickness of the mixed resin 64 disposed on the light emitting diode chip 62 can be adjusted according to the size of the light emitting diode chip 62 and the lead frame 61. The predermined thickness of the mixed resin 64 is not smaller than the relative distance between an edge of the light emitting diode chip 62 and the enclosure 63. A method selected from the collection of a sputtering method, a chemical vapor deposition method, a spray coating method, a screen coating method, a vacuum evaporation method, sol-gel method, and a dispensing method, or any combination of the above is used for forming the mixed resin 64 in an area enclosed by the enclosure. The phosphor in the mixed resin 64 can be Sr₁-ₓ-_{y}BaₓCa_{y}SiO₄:Eu²⁺F, (Sr_{1-x-y}EuₓMn_{y})P_{2+z}O₇:Eu²⁺F, (Ba,Sr,Ca)Al₂O₄:Eu, ((Ba;Sr,Ca)(Mg,Zn))Si₂O₇:Eu; SrGa₂S₄:Eu, ((Ba,Sr,Ca)₁₋ₓEuₓ)(Mg,Zn)₁₋ₓMnₓ))Al₁₀O₁₇, Ca₈Mg(SiO₄)₄Cl₂:Eu,Mn, ((Ba,Sr,Ca,Mg)₁₋ₓEuₓ₎₂SiO₄, Ca₂MgSi₂O₇:Cl, SrSi₃O₈ 2SrCl₂:Eu, BAM:Eu, Sr-Aluminate:Eu, Thiogallate:Eu, Chlorosilicate:Eu, Borate:Ce,Tb, Sr₄Al₁₄O₂₅:Eu, YBO₃:Ce,Tb, BaMgAl₁₀O₁₇:Eu,Mn, (Sr,Ca,Ba)(Al,Ga)₂S₄:Eu, Ca₂MgSi₂O₇:Cl,Eu,Mn, (Sr,Ca,Ba,Mg)₁₀(PO₄)₆Cl₂:Eu ZnS:Cu,Al, (Y,Gd,Tb,Lu,Yb)(Al_{y}Ga1-y)₅O₁₂:Ce, (Sr_{1-x-y-},BaₓCa_{y}Eu_{z})₂SiO₄, (Sr₁-ₐ-_{b}Ca_{b}Ba_{c})SiₓN_{y}O_{z}:Euₐ and Sr₅(PO₄)₃Cl:Euₐ or a mixture of any combination of the above. The enclosure 63 is made of a transparent material, wherein the transparent material can be a transparent resin such as transparent epoxy resin or silicon resin, or can be a material selected from the collection of silicon dioxide, glass, and an encapsulating material. To achieve the effects of the present invention, the invention provides a manufacturing process described as follows. With reference to FIG. 7A, the light emitting diode chip 62 is mounted onto the bonding area 65 of the lead frame 61, and then a metal lead 71 is used for connecting an anode 66 and a cathode 67 of the light emitting diode chip 62 onto a pad 69 of the lead frame. With reference to FIG. 7B, after the step of connecting the metal lead 71, a transparent enclosure 63 is provided to enclose the light emitting diode chip 62 to define a space 100. The enclosure 63 can be formed by a spray coating method, a screen coating method, a sol-gel method, a dispensing method or a die-casting method. A mixed resin 64 containing a phosphor is filled up in the space 100 to complete the manufacture of the white light emitting diode concurrently featuring a uniform color temperature and a uniform angular distribution of brightness. With reference to FIG. 7C, a step of planarizing a surface of the mixed resin 64 can be added to the procedure. In the foregoing procedure as disclosed in FIG. 7B, the transparent enclosure 63 is disposed on the lead frame 61, and then the light emitting diode chip 62 is mounted onto the bonding area 65 of the lead frame 61. The transparent enclosure 63 of this preferred embodiment is made of a transparent material, and the transparent material can be a transparent resin such as transparent epoxy resin or silicon resin, or can be made of a material such as silicon dioxide, glass, and an encapsulation material.

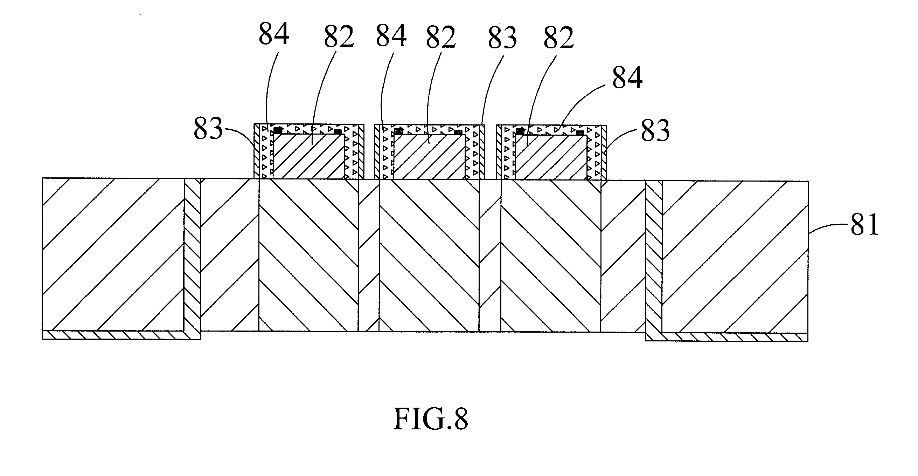

With reference to FIG. 8 for a schematic view of a structure of another light emitting diode in accordance with the present invention, the conductive wire circuit is omitted in the figure. The manufacturing process of the light emitting diode is described as follows. A lead frame 81 is provided, and a plurality of light emitting diode chips 82 are mounted onto the lead frame 81 to form a plurality of transparent enclosures 83, each for enclosing the light emitting diode chip 82 to define a plurality of spaces. The enclosures 83 can be formed by a spray coating method, a screen coating method, a sol-gel method, a dispensing method or a die-casting method, and then a mixed resin 84 containing a phosphor is filled up in the plurality of spaces to complete the manufacture of white light emitting diode concurrently featuring a uniform color temperature and a uniform angular distribution of brightness. A step of planarizing a surface of the mixed resin 84 can be added to the procedure. In this embodiment, the transparent enclosure 83 is made of a transparent material, and the transparent material can be a transparent resin such as transparent epoxy resin or silicon resin, or can be made of a material such as silicon dioxide, glass, or an encapsulation material.

In summation of the description above, the present invention uses the transparent enclosure to enclose the light emitting diode chip to improve the uniformity of the coated phosphor and the light emitting efficiency of the light emitting diode device, and the invention further simplifies the procedure of uniformly coating the phosphor and reduces the manufacturing cost.

It will be apparent to those skilled in the art that various modifications and variations can be made in the present invention without departing from the spirit or scope of the invention. Thus, it is intended that the present invention cover the modifications and variations of this invention provided they come within the scope of the appended claims and their equivalents.

## Claims

1. A light emitting diode manufacturing method, comprising the steps of:
providing a lead frame;
mounting at least one light emitting diode chip onto the lead frame;
forming at least one transparent enclosure to enclose the light emitting diode chip;
and disposing a mixed resin comprising at least one phosphor in an area enclosed by the transparent enclosure.

2. The light emitting diode manufacturing method of claim 1, wherein the distance from the transparent enclosure to the edge of the light emitting diode chip is not greater than the predermined thickness of the mixed resin comprising the phosphor.

3. The light emitting diode manufacturing method of claims 1, further comprising a step of electrically coupling the light emitting diode chip to the lead frame.

4. The light emitting diode manufacturing method of claim 3, wherein after the step of mounting at least one light emitting diode chip onto the lead frame, further comprising the step of:
electrically coupling the light emitting diode chip to the lead frame.

5. The light emitting diode manufacturing method of claim 3, wherein after the step of forming at least one transparent enclosure to enclose the light emitting diode chip, further comprsising the step of:
electrically coupling the light emitting diode chip to the lead frame.

6. The light emitting diode manufacturing method of claim 1, further comprising a step of planarizing a surface of the mixed resin.

7. The light emitting diode manufacturing method of claim 6, wherein a distance from a surface of the light emitting diode chip to a surface of the mixed resin is greater than or equal to a distance from a side wall of the light emitting diode chip to an inner surface of the transparent enclosure.

8. The light emitting diode manufacturing method of claim 1, further comprising a step of connecting an anode and a cathode of the light emitting diode chip to the lead frame.

9. The light emitting diode manufacturing method of claim 8, further comprising a step of the connecting the anode and the cathode of the light emitting diode chip to a thermal conduction pad of the lead frame.

10. A light emitting diode, comprising:
a lead frame;
a light emitting diode chip mounted onto the lead frame;
a transparent enclosure enclosing the light emitting diode chip; and
a mixed resin containing at least one phosphor and being formed in an area enclosed by the transparent enclosure.

11. The light emitting diode of claim 10, wherein the relative distance between the transparent enclosure and the edge of the light emitting diode chip is not greater than the predermined thickness of the mixed resin containing the phosphor.

12. The light emitting diode of claims 10, wherein the lead frame further comprises an electrically connected circuit coupled to the light emitting diode chip and the lead frame.

13. The light emitting diode of claims 10, wherein the mixed resin has a planarized surface.

14. The light emitting diode of claim 10, wherein a distance from a surface of the light emitting diode chip to a surface of the mixed resin is greater than or equal to a distance from a side wall of the light emitting diode chip to an inner surface of the enclosure.

15. The light emitting diode of claims 10, wherein the lead frame has a bonding area provided for mounting the light emitting diode chip.

16. The light emitting diode of claim 10, further comprising a metal lead provided for connecting the light emitting diode chip onto the lead frame.

17. The light emitting diode of claim 16, wherein the lead frame further comprises a thermal conduction pad, and the metal lead is provided for connecting an anode and a cathode of the light emitting diode chip to the thermal conduction pad.
